Europäisches Patentamt

**European Patent Office**

Office européen des brevets

(11) Publication number: **0 233 992 B1**

# EUROPEAN PATENT SPECIFICATION

(45) Date of publication of patent specification: **17.04.91**   (51) Int. Cl.⁵: **G01R 1/073**

(21) Application number: **86113905.3**

(22) Date of filing: **07.10.86**

(54) **Board test fixture.**

(30) Priority: **01.11.85 US 794198**

(43) Date of publication of application:
**02.09.87 Bulletin 87/36**

(45) Publication of the grant of the patent:
**17.04.91 Bulletin 91/16**

(84) Designated Contracting States:
**DE FR GB**

(56) References cited:
**CH-A- 633 403**
**GB-A- 2 146 849**

(73) Proprietor: **Hewlett-Packard Company**
**Mail Stop 20 B-O, 3000 Hanover Street**
**Palo Alto, California 94304(US)**

(72) Inventor: **Cook, Stephen J.**
**2044 Sitka Court**
**Loveland, CO 80537(US)**
Inventor: **Bullock, Michael L.**
**2719 S. County Road 13**
**Loveland, CO 80537(US)**

(74) Representative: **Liesegang, Roland, Dr.-Ing.**
**FORRESTER & BOEHMERT Widenmayer-**
**strasse 4 Postfach 22 01 37**
**W-8000 München 22(DE)**

Rank Xerox (UK) Business Services

## Description

This invention relates to board test fixtures according to the first part of claim 1 (GB-A-2 146 845).

A board test system consists of numerous electronic sources and detectors which are connected through an electric switch, or scanner, to a plurality of contact points referred to as scanner pins. A board test fixture then provides an interface between these scanner pins and the electronic components located on an electronic circuit card. Since the electronic signals which are used to determine whether the electronic component is operating properly must pass through the board test fixture both on their way to and from the electronic component, the board test fixture must maintain the signal quality of these signals to ensure that the electronic component is not incorrectly diagnosed as operating properly or improperly.

In order to insure maximum signal quality, the length of the signal path between the scanner and the electronic circuit card should be kept as short as possible. This normally dictates a vertical configuration with the board test fixture sitting directly on top of the scanner and the electronic card directly on the fixture. However, any board test fixture must be easy to assemble and maintain in order to be cost effective and many prior art vertical configuration test fixtures have sacrificed assembly and maintainability to obtain short lead length. The ability to automate assembly of the fixture is also an important feature.

Various prior art solutions have attempted to address these requirements. A first prior art solution (CH-A-633 403) uses a stiff arrangement to conduct the electronic signal directly from a spring loaded scanner pin to the electronic component under test. The probe pin passes through a first plate having a hole for each scanner pin and through a second plate having holes drilled according to the location of the electronic components on the card. Centering pins serve as positioning means for holding the first plate in position with respect to the second plate.

A second prior art solution replaces the stiff probe pin with a flexible probe pin. This permits the holes in both the first and second plate to be at right angles to the scanner pins and electronic components assuring a low resistance contact with the electronic component.

Both the first and second prior art solutions are impractical because they require a large number of scanner pins in order for a scanner pin to be located sufficiently close to the component to be able to use a straight or slightly bent pin. More scanner pins mean additional expensive pin electronics. In order to reduce the number of scanner pins, the fixturing method should permit signals from the scanner pins to be routed, or translated, to probe pins located at a different x and y axis positions from the scanner pins with respect to the plane of the probe plate. For incircuit and functional testing, the fixturing method must permit translation between the component location and the scanner pin location.

A third prior art solution according to the above-mentioned GB-A-2 146 849 permits translation at the expense of long connecting wires. The fixture again has two plates, the first plate drilled according to the locations of the electronic components on the card and the second plate with holes positioned above the scanner pins. A spring loaded probe is mounted in the first plate making electrical contact with the electronic components on the card. An interconnect wire is mounted in the second plate to make electrical contact with the scanner pin. This wire is typically quite long to enable the fixture to be opened for easy building and maintenance. Because the wire is long, the electrical performance of the third solution is inferior. A fourth prior art solution is similar to the third prior art solution but uses short wires between the probe pin and the interconnect pin. However, in order to use short wires, the second plate of the fourth solution is divided into interconnect strips. The interconnect strips are arranged in rows below the probe plate. Electrical connections are made one row at a time between the probe pins and the interconnect pins located in these strips. Starting at one end and after each row of connections is made, each strip is sequentially mounted across the bottom of the fixture. The fourth prior art solution, although offering good electrical performance, is difficult to wire, especially if there is a large number of x and y axis translations. This solution is impossible to automate and service is very difficult.

The fifth and final prior art solution is referred to as the "basic matrix". This solution uses a printed circuit board to perform the x and y axis translation. The probes which contact the electronic components are mounted directly to the top of the printed circuit board and the scanner pins contact the bottom of the printed circuit board to complete the connection. This solution is expensive requiring a custom printed circuit board for each fixture and special probes. Furthermore, this solution causes scanner pins located directly under probes to be made unusable, a very undesirable feature.

The problem underlying the invention is to provide a low cost, easy to build test fixture for which assembly is automatable. The test fixture should minimize the loss of scanner pins and provide for translation in the x and y axis directions between probe and scanner pin.

This problem is solved by claim 1.

In accordance with the present invention, an apparatus is described for interfacing an automatic board test system to an electronic circuit card. This interface permits reliable electrical connections between the test system and electronic components located on the circuit card. The apparatus according to the invention maximizes the quality of the connection to the test system while permitting easy and automatic assembly of the test fixture. The apparatus works equally well with both vacuum actuated and mechanically actuated systems.

The present invention is superior to the prior art in several ways. First, the apparatus is a vertical fixturing scheme which minimizes the interconnection lead length. Second, the apparatus is easy to assemble and the assembly may be automated to further reduce the cost. Third, the apparatus avoids where possible making the interconnection points to the test system unusable. Finally, the apparatus does not require the electronic components to be located on a grid of any sort; the electronic components may be located anywhere on the card.

The invention and advantageous features thereof are described in the following with reference to the accompanying drawings, in which

Figure 1 is a fragmentary elevational view of the preferred embodiment of the present invention in a first position with an electronic circuit card and

Figure 2 is a fragmentary elevational view of the preferred embodiment of the present invention in a second position with the electronic circuit card.

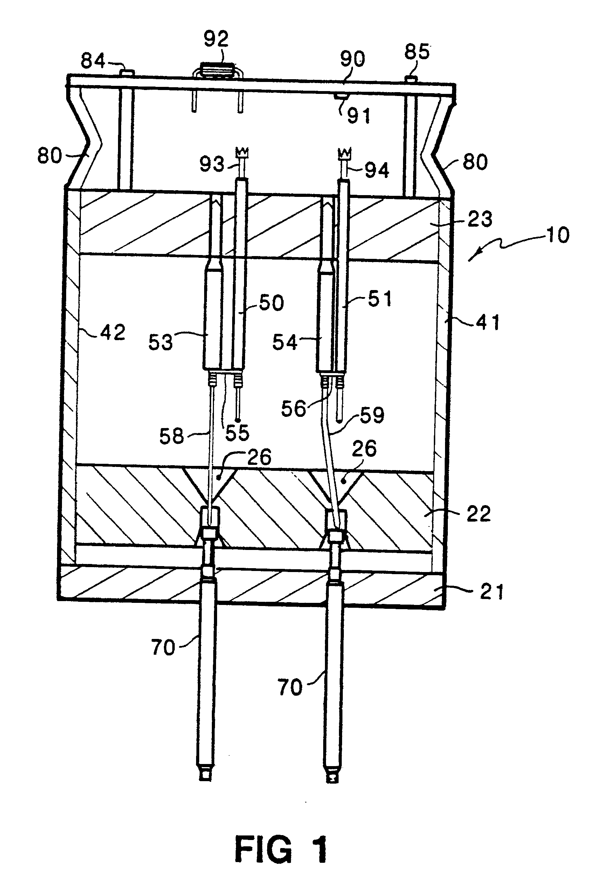

Figure 1 is a fragmentary elevational view of the preferred embodiment of the present invention in a first position with an electronic circuit card. The test fixture comprises an alignment plate 22, probe plate 23, two probe assemblies 50 and 51, two interconnecting pins 53 and 54, interconnect wire 55 and 56, walls 41 and 42, alignment pins 84 and 85, and vacuum seal 80. The electronic circuit card to be tested consists of a printed circuit board 90, component 92, and printed circuit trace 91. The printed circuit board 90 has two tooling holes which may be used for alignment. A vacuum chamber is formed by the board 90, vacuum seal 80, and probe plate 23. A vacuum manifold, not shown, is attached over a hole in the probe plate to draw the air from the vacuum chamber. Vacuum is used in the preferred embodiment to force the electronic circuit card against the probe assembly, although mechanical means may also be used. The test fixture is mounted on the test system scanner. The scanner consists of a plate 21 with scanner pins 70. The construction of scanners is well known in the prior art as are various mounting and locking mechanism for holding the test fixture to the scanner. The present invention is capable of operating with a wide variety of scanners and mounting and locking mechanisms.

The probe assembly typically consists of a probe socket which is mounted into the hole in the probe plate and a probe mechanism having probe tip 94 which is inserted into the probe socket. The probe mechanism may be replaced as the probe tip 93 or 94 wears out. The probe socket consists of a tube which accepts the probe mechanism and a square wire wrap post. The probe mechanism consists of a probe tip 93 or 94 and a spring to bias the probe tip 93 or 94 to its maximum extended position in a housing which fits in the probe socket. Both probe sockets and probe mechanisms, including a variety of probe tips, are well known in the art.

The interconnecting pin 53 or 54 consists of insulated body about the same length as the probe assembly and a wire wrap post 58 or 59 which is considerably longer than the wire wrap post of the probe assembly 50 or 51. In the preferred embodiment of the present invention, the wire wrap post 58 or 59 of the interconnecting pin is approximately 25 mm (one inch) long.

The probe plate 23 is constructed from a strong insulating material. In the preferred embodiment of the present invention, a sheet of plastic approximately 13 mm (one-half of an inch) thick is used as the probe plate. In the preferred embodiment of the present invention, the plate 23 has a manifold hole which is not shown. The plate 23 is then drilled for the probe assemblies 50 and 51, interconnecting pins 53 and 54 and alignment pins 84 and 85. The locations of the probe assemblies 50 and 51 and the alignment pins 84 and 85 are determined by the locations of the components and traces on the electronic circuit card 90. These locations are often available from CAD/CAM systems as points. This permits a fixture builder to select the points from the CAD/CAM files for the electronic circuit card to be tested and to have the probe plate automatically drilled at these points. Automatic drilling is considerably less expensive than manual drilling. The location of the interconnecting pins is determined, with one important exception, from the location of the scanner pins. The scanner pins are on a fixed grid which may also be automatically drilled. The exception occurs when a probe assembly is located directly over a scanner pin as shown by probe assembly 51 In Figure 1. For these cases, the hole for interconnecting pin is drilled off to one side. The maximum distance to offset the hole for the interconnecting pin is determined by the length of the interconnecting pin and the tolerances of the scanner pins and fixture. For the preferred embodiment of the present invention, 2.54 mm (0.100 of an inch) is used for the offset. The holes for the interconnecting pins do not need to pass completely through the probe plate 23, although in the preferred embodiment they do for convenience of drilling. Drilling the holes for the interconnecting pins may also be computerized by the CAD/CAM system since the system knows the location of both the components and the scanner grid.

After the probe plate 23 is drilled, the alignment pins 84 and 85, the probe assemblies 50 and 51 and the interconnecting pins 53 and 54 are installed by pressing the pin or assembly into the probe plate, a process which lends itself to automation. The probe plate must then be wired. The x and y axis translation features, as well as the multiple connection capabilities of the fixture are provided by wiring each probe assembly 50 and 51 to one or more interconnecting pins 53 and 54. In the preferred embodiment of the present invention, the method of wiring is by wire wrapping. Wire wrapping is fast and lends itself to automation. Figure 1 illustrates the interconnect wires 55 and 56 used for connecting the interconnecting pin to the probe assembly in the preferred embodiment of the present invention.

After the probe plate has been wired, the fixture is assembled by connecting the probe plate 23 to the alignment plate 22. The primary requirement is to position the alignment plate 22 at a constant fixed distance, from the probe plate 23. In the preferred embodiment of the present invention, the alignment plate is located approximately 28.6 mm ± 1.6 mm (an one and one-eighth inches plus or minus one sixteenth of an inch), from the probe plate. The preferred embodiment of the present invention uses a wall 41 and 42 to position the alignment plate with respect to the probe plate. Walls offer the added advantage of keeping dirt out, reducing the possibility of accidental damage to the fixture, and adding stiffness to the probe plate to reduce deflection. Alternate methods, including posts, may be used.

The alignment plate 22 has holes 26 on a grid which corresponds to the location of the scanner pins 70. The wire wrap posts of the interconnecting pins 58 pass through these holes in the alignment plate to make contact with the scanner pins. The holes 26 in the alignment plate 22 are bored out to a tapered shape to assist in assembly. These tapered holes 26 are especially important in the special case described above where a probe assembly lies directly above the scanner pin. In this case as shown in Figure 1, the wire wrap post 59 of the interconnecting pin 54 which has been offset to on side of probe pin 51 is bent as it passes through the hole 26 in the alignment plate 22. The tapered bore of the hole 26 makes assembly of the offset interconnecting pins possible and permits easy disassembly for maintenance and repair.

Accurate alignment of the test fixture is essential for reliable operation. Alignment for the printed circuit board 90 to probe plate 23 is maintained by the alignment pins 84 and 85. Two or more alignment pins may be used depending on the size of the board. Alignment between the probe plate 23 and the alignment plate 22 is not critical since the wire wrap posts of the interconnecting pins are free to bend although it does determine the required length of the wire wrap post of the interconnecting pin. The alignment between the alignment plate 22 and the scanner 21 is controlled through the mounting and locking hardware well known in the prior art.

The method of operation of the test fixture is as follows. The printed circuit board is placed on the fixture with the alignment pins 84 and 85 of the test fixture passing through the tooling holes in the printed circuit board 90. The component 92 and trace 91 of the electronic circuit card must now be brought into contact with the probe tips 93 and 94. This may be achieved in several ways including vacuum and mechanical actuating means. The preferred embodiment of the present invention uses a vacuum actuating means. Air is removed from the vacuum chamber created between the electronic circuit card and the probe plate 23. A seal 80 is used to maximize the force and reduce noise. As the electronic circuit card is drawn toward the probe plate, the probe tips 93 and 94 of the spring loaded probe assemblies 50 and 51 push against the ends of the component 92 and the trace 91 making a good low resistance contact.

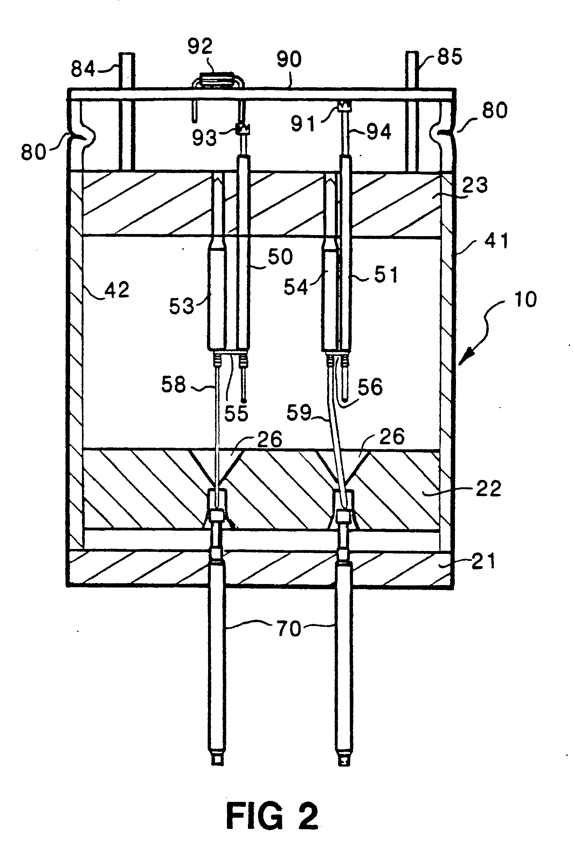

Figure 2 is a fragmentary elevational view of the preferred embodiment of the present invention in a second position with the electronic circuit card. Figure 2 illustrates the printed circuit board with the vacuum applied in position for testing. When the vacuum is released the card returns to the position in Figure 1 and may be easily removed and the next card to test installed.

Mechanical means may also be used for driving the electronic circuit card against the probe tips. This may be accomplished, for example, by placing a weight on top of the board. The present invention works well with any method of forcing the electronic circuit card against the probe tips.

## Claims

1. A board test fixture for interfacing electronic signals from a card (90) having electronic devices (92) at predetermined locations on the card to a test system interface having contacts at fixed predetermined locations, said board test fixture comprising:
   a probe plate (23) having a first plurality of holes at locations corresponding to the electronic devices (92) on the card (90);

probing means (50,51) for sending and receiving electronic signals to the card (90) located in the first plurality of holes in the probe plate (23);

an alignment plate (22) parallel to the probe plate (23) having a plurality of holes at fixed predetermined locations corresponding to the contacts of the test system interface;

interconnecting means (53,54) for conducting electronic signals into the fixture from the contacts of the test system interface, said interconnecting means extending through the plurality of holes in the alignment plate, said holes having a means (26) for centering the interconnecting means (53,54) against the contacts of the test system interface; and

conducting means (55,56) for conducting electronic signals between the probing means (50,51) and the interconnecting means (53,54); **characterized** in

that said probe plate (23) has a second plurality of holes at fixed predetermined locations corresponding to the contacts of the test system interface unless offset to avoid a hole from the first plurality of holes,

that said interconnecting means (53,54) are located in the second plurality of holes on the probe plate (23), and that positioning means (41,42,84,85) are provided for holding the card (90) and the probe plate (23) in position with respect to the alignment plate (22).

2. A fixture as in claim 1, **characterized** by actuating means for moving the card (90) relative to the probe plate (23) causing the card to contact the probing means (50,51).

3. A fixture as in claim 2, **characterized** in that the actuating means withdraws air from a vacuum chamber formed by the card (90) and probe plate (23) to hold the card (90) against the probing means (50,51).

4. A fixture as in claim 2, **characterized** in that the actuating means places a mechanical force against the card (90) in the direction of the probe plate (23) to hold the card against the probing means (50,51).

**Revendications**

1. Monture pour tester des plaquettes à circuits, destinée à transmettre des signaux électroniques entre une carte (90) présentant des dispositifs électroniques (92) à des emplacements prédéterminés sur la carte et une interface d'un système de test possédant des contacts à des emplacements fixes prédéterminés, la monture comprenant:

une plaque porte-sondes (23) présentant une première pluralité de trous à des points correspondant aux dispositifs électroniques (92) sur la carte (90);

des moyens formant des sondes (50, 51) destinées à envoyer des signaux électroniques à la carte (90) et à recevoir des signaux électroniques de cette carte, les sondes étant situées dans la première pluralité de trous de la plaque porte-sondes (23);

une plaque d'alignement (22) parallèle à la plaque porte-sondes (23) et présentant une pluralité de trous à des points fixes prédéterminés, correspondant aux contacts de l'interface du système de test;

des moyens d'interconnexion (53, 54) pour conduire des signaux électroniques dans la monture depuis les contacts de l'interface du système de test, les moyens d'interconnexion s'étendant à travers la pluralité de trous de la plaque d'alignement, les trous comportant un moyen (26) pour centrer les moyens d'interconnexion (53, 54) en vue de leur application contre les contacts de l'interface du système de test; et

des moyens conducteurs (55, 56) pour transmettre des signaux électroniques entre les sondes (50, 51) et les moyens d'interconnexion (53, 54);

caractérisée en ce

que la plaque porte-sondes (23) présente une seconde pluralité de trous à des points fixes prédéterminés, correspondant aux contacts de l'interface du système de test, sauf si un décalage a été prévu pour éviter un trou de la première pluralité de trous,

que les moyens d'interconnexion (53, 54) sont situés dans la seconde pluralité de trous sur la plaque portesondes (23) et

que des moyens de positionnement (41, 42, 84, 85) sont prévus pour maintenir la carte (90) et la plaque portesondes (23) en position par rapport à la plaque d'alignement (22).

2. Monture selon la revendication 1, caractérisée par un moyen d'actionnement pour déplacer la carte (90) par rapport à la plaque porte-sondes (23), de manière que la carte soit amenée en contact avec les sondes (50, 51).

3. Monture selon la revendication 2, caractérisée en ce que le moyen d'actionnement évacue de l'air d'une chambre à vide formée par la carte (90) et la plaque porte-sondes (23) en vue du maintien de la carte (90) contre les sondes (50, 51).

4. Monture selon la revendication 2, caractérisée en ce que le moyen d'actionnement applique une force mécanique à la carte (90), en direction de la plaque porte-sondes (23), en vue du maintien de la carte contre les sondes (50, 51).

**Ansprüche**

1. Leiterplattenprüfhalterung zum Übertragen elektrischer Signale von einer Leiterplatte (90) mit elektrischen Vorrichtungen (92) an vorbestimmten Stellen auf der Leiterplatte zu einem Interface eines Testsystems mit Kontakten an vorbestimmten Stellen, wobei die Halterung umfaßt:
eine Prüfplatte (23) mit einer Anzahl erster Löcher an Stellen, die für den elektrischen Baustein (92) auf der Leiterplatte (90) entsprechend angeordnet sind;
Prüfmittel (50, 51) zum Senden und Empfangen elektrischer Signale zu und von der Leiterplatte (90), wobei diese Prüfmittel in der ersten Anzahl Löcher in der Prüfplatte (23) angeordnet sind;
einer parallel zur Prüfplatte (23) angeordneten Ausrichtplatte (22) mit einer Anzahl Löcher an vorherbestimmten festen Orten entsprechend zu Kontakten des Testsystem-Interfaces;
Verbindungsmitteln (53, 54) zum Leiten elektrischer Signale in die Halterung aus den Kontakten des Testsystem-Interfaces, wobei die Verbindungsmittel sich durch die Löcher in der Ausrichtplatte erstrecken und 753 die Löcher Mittel (26) zum Zentrieren der Verbindungsmittel (53, 54) gegen die Kontakte des Testsystem-Interfaces haben; und
Leitungsmittel (55, 56) zum Leiten elektrischer Signale zwischen den Prüfmitteln (50, 51) und den Verbindungsmitteln (53, 54);
**dadurch gekennzeichnet,**
daß die Prüfplatte (23) eine zweite Anzahl Löcher an vorbestimmten Stellen entsprechend den Kontakten des Testsystem-Interfaces - abgesehen von einem Versatz zum Vermeiden eines Loches der ersten Anzahl Löcher - aufweist,
daß die Verbindungsmittel (53, 54) in der zweiten Anzahl Löcher in der Prüfplatte (23) aufgenommen sind, und
daß Positioniermittel (41, 42, 84, 85) zum Halten der Leiterplatte (90) und der Prüfplatte (23) in Position bezüglich der Ausrichtplatte (22) vorgesehen sind.

2. Halterung nach Anspruch 1, **gekennzeichnet durch** Betätigungsmittel zum Bewegen der Leiterplatte (90) relativ zur prüfplatte (23), um die Leiterplatte in Kontakt mit den Prüfmitteln (50, 51) zu bringen.

3. Halterung nach Anspruch 2, **dadurch gekennzeichnet,** daß die Betätigungsmittel Luft aus einer Vakuumkammer absaugen, welche durch die Leiterplatte (90) und die Prüfplatte (23) gebildet wird, um die Leiterplatte (90) an den Prüfmitteln (50, 51) zu halten.

4. Halterung nach Anspruch 2, **dadurch gekennzeichnet,** daß die Betätigungsmittel eine mechanische Kraft auf die Leiterplatte (90) in Richtung auf die Prüfplatte (23) ausüben, um die Leiterplatte gegen die Prüfmittel (50, 51) gedrückt zu halten.

**FIG 1**

**FIG 2**